# EUROPEAN PATENT APPLICATION

(11) **EP 1 523 041 A1**
(43) Date of publication of application: **13.04.2005**
(21) Application number: 04029111.4
(22) Date of filing: 08.12.2004
(51) Int. Cl.: H01L 25/075, H01L 33/00, H01L 23/427, F21V 29/02, F21K 7/00

(54) **Light emitting diode assembly having high-performance heat dissipation means**

(71) Applicant: Chen, Jeffrey, Hsinchu (TW)
(72) Inventor: Chen, Jeffrey, Hsinchu (TW)
(74) Representative: Casalonga, Axel

(57) **Abstract**

A light source assembly includes a vapor chamber, which has an electrical circuit installed in the top surface, an insulation layer covered in between the top surface of the vapor chamber and the electrical circuit, and light emitting diodes installed in the top surface directly of the vapor chamber and electrically connected to the electrical circuit for producing light upon connection of electricity to the electrode circuit means and the vapor chamber, and a heat sink installed in the bottom surface of the vapor chamber for dissipation of heat energy from the vapor chamber into outside open air.

## Description

### BACKGROUND OF THE INVENTION

### 1. Field of the Invention:

The present invention relates to a light source and more particularly, to a light source assembly having high-performance heat dissipation means that dissipates heat efficiently during light emitting operation.

### 2. Description of the Related Art:

Regular LCDs (liquid crystal displays) commonly have a backlight formed of a CCFL (Cold Cathode Fluorescent Lamp. Following fast development of semiconductor technology, LEDs (Light Emitting Diodes) have been intensively used to substitute for CCFLs. A CCFL has a certain thickness. Due to thickness problem, a CCFL is not an ideal light source for use in many small mobile electronic apparatus. Further, interference occurs when the voltage of a CCFL reaches 600V. Mercury contamination is another problem a CCFL may cause. Further, in comparison to natural light, color saturation of a CCFL reaches only about 70% of natural light. Therefore, it is the market tendency to substitute LEDs for CCFLs.

LEDs have been intensively used in many fields, for example, light source in the face panel of a stereo equipment, backlight for the buttons of a cellular phone, backlight for the display screen of a cellular phone. Following development of high brightness LEDs, the application of LEDs is greatly widened. For example, high brightness LEDs can be used for illumination purpose. However, high power LEDs (>0.5W) consume much power and generate much more heat during working. Therefore, it is necessary to dissipate heat from high power LEDs during their operation.

### SUMMARY OF THE INVENTION

The present invention has been accomplished under the circumstances in view. It is one object of the present invention to provide a light source assembly, which dissipates heat efficiently when turned on to emit light. It is another object of the present invention to provide a light source assembly, which dissipates heat efficiently so that light emitting devices can be installed in a high density manner. It is still another object of the present invention to provide a light source assembly, which dissipates heat efficiently for a wide range application.

To achieve these and other objects of the present invention, the light source assembly comprises a vapor chamber, which has a first surface, a second surface opposite to the first surface, and electrode circuit means installed in the first surface, an insulation layer covered in between the top surface of the vapor chamber and the electric circuit means, and a light source formed of a plurality of light emitting devices and installed in the first surface of the vapor chamber and electrically connected to the electric circuit means for generating light upon connection of electricity to the electric circuit means and the vapor chamber. It is important that, for giving a best thermal dissipation path, the light emitting devices should be directly placed on the top surface of the vapor chamber.

### BRIEF DESCRIPTION OF THE DRAWINGS

FIG. 1 is an elevational view of a light source assembly according to the present invention.
FIG. 2 is a schematic sectional view in an enlarged scale of a part of the light source assembly shown in FIG. 1.
FIG. 3 illustrates a heat sink fastened to the bottom surface of the vapor chamber of the light source assembly according to the present invention.
FIG. 4 illustrates heat pipes installed in respective bottom channels at the bottom side of the vapor chamber of the light source assembly according to the present invention.

### DETAILED DESCRIPTION OF THE PREFERRED EMBODIMENT

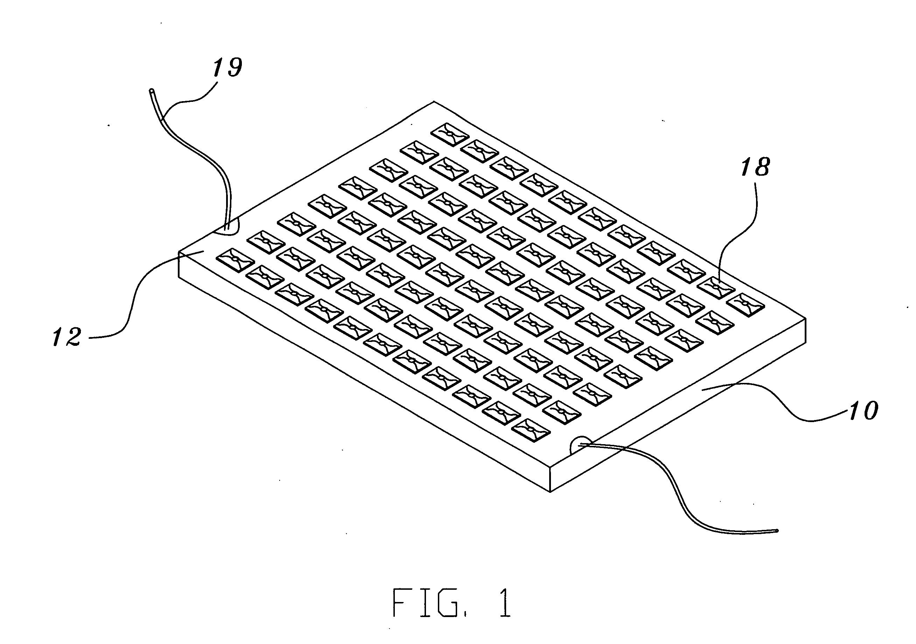

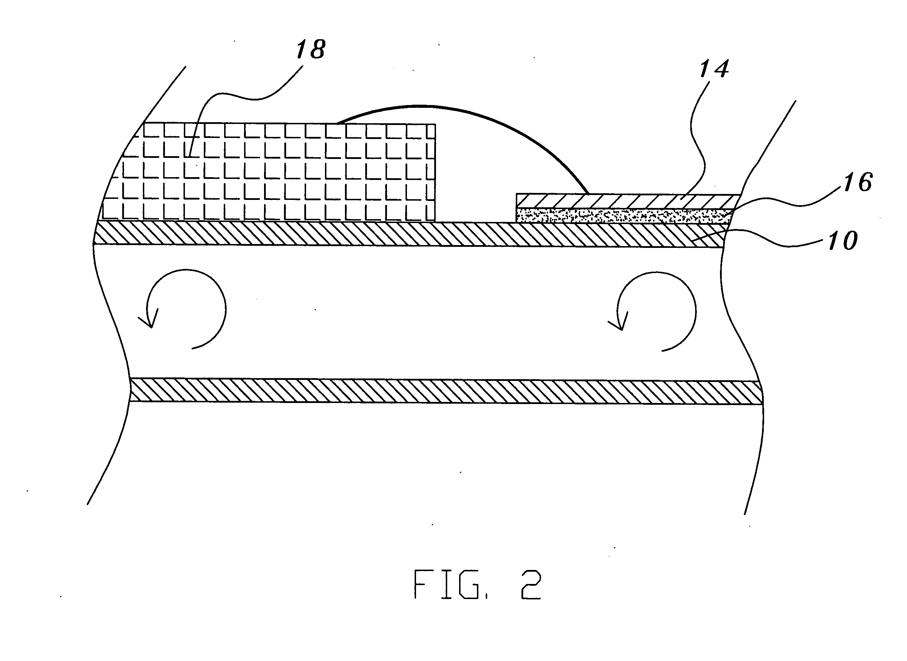

Referring to FIGS. 1 and 2, a light source assembly in accordance with the present invention is shown comprised of a vapor chamber **10** and a light source formed of a plurality of light emitting devices **18.** The vapor chamber **10** is filled with a work fluid (not shown) and maintained in a vacuum status. By means of a phase transfer of the working from liquid phase to vapor phase after absorption of heat, the vapor chamber 10 achieves rapid spreading of heat. The vapor chamber **10** is preferably made of copper, nickel, aluminum, or their alloy. The vapor chamber 10 has a top surface **12** and a bottom surface (not shown). An electric circuit **14** is installed in the top surface **12** of the vapor chamber **10.** The electric circuit **14** is made of aluminum or copper. An insulation layer **16** is provided between the electric circuit **14** and the vapor chamber **10** to isolate the electric circuit **14** from the vapor chamber **10.** The insulation layer **16** is formed of polymers or ceramics. The light emitting devices **18** are installed in the top surface **12** of the vapor chamber **10** and electrically connected with the vapor chamber **10.** The light emitting devices **18** according to the present preferred embodiment are un-assembled chips of light emitting diode respectively electrically connected to the electric circuit **14** by wire bonding or soldering method to give electrically connected with the electric circuit **14** to the positive and negative poles of power supply by electric wires **19.** When power is on, the electric circuit **14** and the vapor chamber **10** form a power circuit to turn on every light emitting device **18.** Further, the vapor chamber 10 can be made in the form of a box ,a flatted heat pipe, or heat tube. The electrical connection between each light emitting device **18** and the electric circuit **14** can be achieved by wire bonding or soldering process.

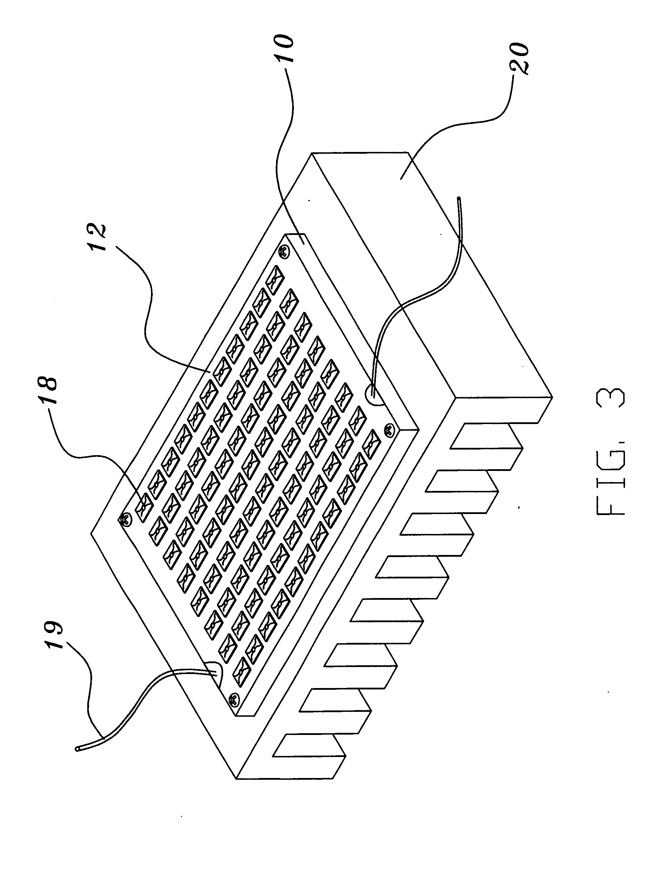

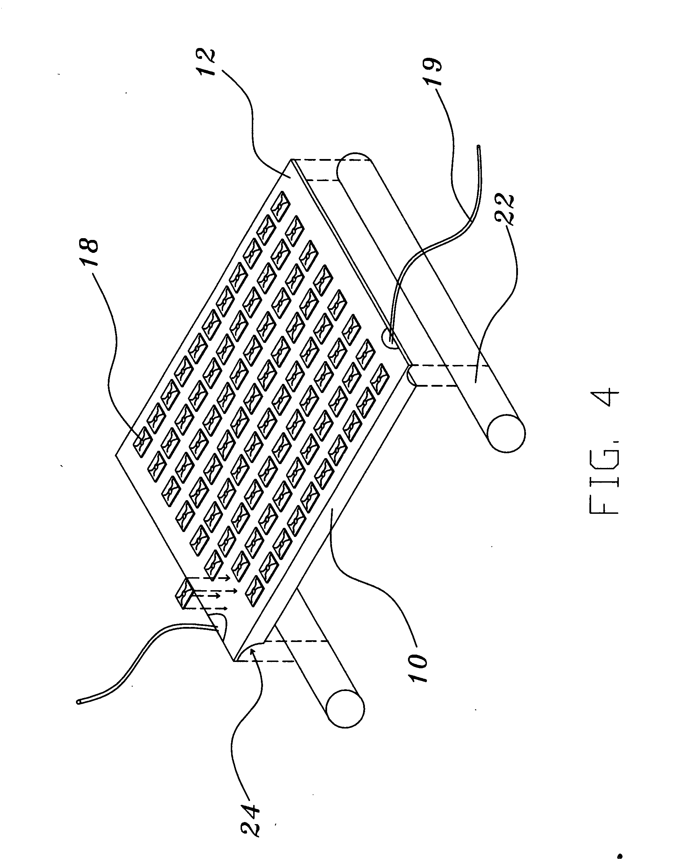

During working of the light emitting devices **18,** every light emitting device **18** generates a certain amount of heat that is absorbed by the top surface **12** of the vapor chamber **10** and rapidly spread the heat to all surface besides the heating region, generally, the bottom surface is the most available one. Therefore, a heat dissipation structure may be installed in the bottom surface of the vapor chamber **10** to dissipate heat into outside open air. The heat dissipation structure can be formed of a heat sink **20** as shown in FIG. 3, or additional installation of the heat pipes **22** as shown in FIG. 4.

Referring to FIG. 3, the heat sink **20** is fixedly fastened to the bottom surface of the vapor chamber **10** for dissipation of heat energy from the bottom surface of the vapor chamber **10** into outside open air. Further, a thermal interface material (TIM) may be filled in between the heat sink **10** and the vapor chamber **10** to lower thermal contact resistance.

Referring to FIG. 4, two channels **24** are symmetrically arranged along the two opposite lateral sides of the vapor chamber **10** at the bottom, and two heat pipes **22** are respectively mounted in the channels **24.**

Referring to FIGS. 1∼4, after installation of the heat dissipation structure in the bottom side of the vapor chamber **10,** a protective layer of polymeric compound that admits light is covered on the top surface **12** of the vapor chamber **10** over the light emitting devices **18** for assembly structure protection.

When in use, the electric wires **19** are connected to the power source. When switched on power supply, the light emitting devices **18** are turned on to emit light. During working of the light emitting devices **18**, the vapor chamber **10** absorbs heat energy from the light emitting devices **18** and transfers absorbed heat energy to the heat dissipation structure (of the heat sink **20** or heat pipes **22**), which in turn dissipates heat energy into outside open air.

A prototype of light source assembly has been constructed with the features of FIGS. 1-4. The light source assembly functions smoothly to provide all of the features discussed earlier.

Although particular embodiments of the invention have been described in detail for purposes of illustration, various modifications and enhancements may be made without departing from the spirit and scope of the invention.

## Claims

1. A light source assembly comprising:
a vapor chamber, said vapor chamber comprising a first surface, a second surface opposite to said first surface, and electrical circuit means installed in said first surface;
an insulation layer covered in between the top surface of said vapor chamber and said electrical circuit means; and
a light source formed of at least one light emitting device and installed directly on the first surface of said vapor chamber and electrically connected to said electrical circuit means for producing light upon connection of electricity to said electrode circuit means and said vapor chamber.

2. The light source assembly as claimed in claim 1, wherein each said light emitting device is an un-assembled chip of light emitting diode.

3. The light source assembly as claimed in claim 1, wherein said electrical circuit means is electrically connected to said light emitting device by wire bonding or soldering.

4. The light source assembly as claimed in claim 1, further comprising a heat dissipation device installed in said vapor chamber for dissipation of heat energy from said vapor chamber into outside open air.

5. The light source assembly as claimed in claim 4, wherein said heat dissipation device is comprised of a heat sink installed in the second surface of said vapor chamber.

6. The light source assembly as claimed in claim 5, wherein said heat dissipation device is comprised of at least one heat pipe installed in said vapor chamber beyond said first surface.

7. The light source assembly as claimed in claim 5, wherein said heat dissipation device is comprised of a heat sink installed in said vapor chamber beyond said first surface.

8. The light source assembly as claimed in claim 1, further comprising a polymeric protection layer covered on the first surface of said vapor chamber and said light source for protecting said light source.

9. The light source assembly as claimed in claim 1, wherein said vapor chamber is made of a material selected from a higher thermal conductive metal group including copper, aluminum, silver, nickel, and their alloy.

10. The light source assembly as claimed in claim 1, wherein said electical circuit means is made of a material selected from a electrical conductive materials group including copper, silver, nical and aluminum, etc.

11. The light source assembly as claimed in claim 1, wherein said insulation layer is formed of a material selected from a material group including polymers and ceramics.
